# EUROPEAN PATENT SPECIFICATION

(11) **EP 1 547 146 B1**
(45) Date of publication and mention of the grant of the patent: **14.09.2011**
(21) Application number: 03762846.8
(22) Date of filing: 09.07.2003
(51) Int. Cl.: H01L 21/762, H01L 21/20

(54) **METHOD OF TRANSFERRING OF A LAYER OF STRAINED SEMICONDUCTOR MATERIAL**
VERFAHREN ZUM TRANSFER EINER SCHICHT GESPANNTEN HALBLEITERMATERIALS
PROCEDE POUR TRANSFERER UNE COUCHE DE MATERIAU SEMI-CONDUCTEUR CONTRAINT

(30) Priority: 09.07.2002 FR 0208602
(43) Date of publication of application: 29.06.2005
(73) Proprietor: S.O.I.Tec Silicon on Insulator Technologies, 38190 Bernin (FR)
(72) Inventor: GHYSELEN, Bruno, F-38170 Seyssinet (FR); BENSAHEL, Daniel, F-38100 Grenoble (FR); OSTERNAUD, Bénédicte, F-38380 Saint Laurent du Pont (FR)
(74) Representative: Texier, Christian
(86) International application number: PCT/IB2003/003341
(87) International publication number: WO 2004/006326

(56) References cited:
- WO-A-01/99169
- WO-A-02/15244
- WO-A-02/27783
- WO-A-02/071493
- WO-A-02/080241
- US-A- 6 059 895
- US-A- 6 059 895
- US-A- 6 059 985
- US-A1- 2002 030 227
- US-B1- 6 323 108
- PATENT ABSTRACTS OF JAPAN vol. 2000, no. 23, 10 February 2001 (2001-02-10) -& JP 2001 168342 A (FUJITSU LTD), 22 June 2001 (2001-06-22)
- MIZUNO T ET AL: "High performance strained-Si p-MOSFETs on SiGe-on-insulator substrates fabricated by SIMOX technology" ELECTRON DEVICES MEETING, 1999. IEDM TECHNICAL DIGEST. INTERNATIONAL WASHINGTON, DC, USA 5-8 DEC. 1999, PISCATAWAY, NJ, USA,IEEE, US, 5 December 1999 (1999-12-05), pages 934-936, XP010372110 ISBN: 0-7803-5410-9

## Description

The present invention relates to the transfer of a thin layer of a donor wafer to a receiving substrate in order to form structures such as a semiconductor-on-insulator structure.

The invention relates more particularly to carry out this transfer in order to produce electronic structures comprising strained layers.

The expression "strained layer" is understood here to mean any layer of a semiconductor material whose crystallographic structure is mainly elastically strained in tension or in compression during crystal growth, such as epitaxy, requiring at least one lattice parameter to be substantially different from the nominal lattice parameter of this material, a nominal lattice parameter can be understood as the lattice parameter of the material in its bulk form in equilibrium.

Conversely, the term "relaxed layer" means a layer of a semiconductor material, having a crystallographic relaxation rate (as measured by X-ray diffraction or Raman spectroscopy) superior to 50%. A layer having 100% relaxation rate, has a lattice parameter substantially identical to the nominal lattice parameter of the material of the layer.

A transfer aim is to produce, in particular, a "semiconductor-on-insulator" (also called here "SeOl") structure.

Such a strain exerted within a semiconductor material may in fact exhibit physical and/or electrical properties worthwhile exploiting.

Thus, for example, the main benefit of tension-strained silicon layers (also called strained Si layers) consists mainly in the fact that the charge carriers (such as holes and electrons) have a higher mobility than that usually found in relaxed Si layers.

The strained Si layers may in this regard reach a charge carrier mobility 100% higher than that within relaxed Si layers.
To produce such strained Si layers, it is known to grow a silicon film by epitaxy on a base composed of silicon and germanium.

Since germanium in equilibrium has a lattice parameter slightly greater than that of the silicon in equilibrium (greater by approximately 4%), the presence of germanium in a defined amount in the silicon thus makes it possible to slightly increase the lattice parameter compared with a base consisting only of silicon.

This silicon-germanium base (also called SiGe base) will thus strain the epitaxially grown Si film so as to make its lattice parameter substantially identical to its own.

In practice, a substrate made of bulk SiGe is not available on the market and the SiGe base is then generally composed of a single-crystal Si support substrate on which a relaxed SiGe layer is produced via a buffer layer.

The term "buffer layer" is understood to mean an intermediate layer between two crystallographic structures with different lattice parameters, having in the region of one of its faces a lattice parameter substantially identical to that of the first structure and in the region of its other face a lattice parameter substantially identical to that of the second structure.

The buffer layer inserted between the Si support substrate and the relaxed SiGe layer is generally made of SiGe, with a quantity-wise proportion of germanium which progressively increases through the thickness of the support substrate towards the relaxed layer.

Thus, it makes it possible to:
- gradually increase the germanium content from the support substrate towards the relaxed layer;
- confine defects associated with the difference in lattice parameter so that they are buried;
- give a sufficiently thick relaxed SiGe layer stability with respect to an Si film grown epitaxially on its surface in order to strain the latter so as to modify its lattice parameter without influencing that of the relaxed SiGe layer.

For all these reasons, the buffer layer must be sufficiently thick, typically having a value between one and three microns.

In the field of application of the present invention, this type of wafer is used as a donor in the sense that at least one layer of material is removed therefrom in order to transfer it to a receiving substrate.

This transfer generally comprises a first step of bonding the donor wafer to the receiving substrate.

A second step consists in keeping of the bonded donor wafer only at least one thin layer adjacent to the bonding region, by removing the superfluous parts from the donor wafer.

Several processes and techniques for transferring semiconductor layers, such as Si or SiGe layers, have thus been proposed, the donor wafer comprising in succession a single-crystal silicon support substrate and a thickness of SiGe.

Zhi-Yuan Cheng et al. of Massachusetts Institute of Technology have presented, in a document entitled "SiGe-On-Insulator (SGOI): Substrate Preparation and MOSFET Fabrication for Electron Mobility Evaluation" (2001 IEEE International SOI Conference, 10/01), two known techniques for transferring layers from the said donor wafer comprising an SiGe buffer layer:
- the first layer transfer technique is called "etch-back": it consists in removing, by chemical-mechanical means, the single-crystal Si support substate and the SiGe buffer layer after bonding the donor wafer to the receiving substrate.

In particular, etching called "selective" etching is used to remove the buffer layer, as this has the ability of etching the strained SiGe of the buffer layer more easily than the relaxed SiGe of the surface layer. The relaxed SiGe layer then behaves as a "stop layer" for the etching, since the etching stops at least partly at the level thereof.

Finally, a strained Si film is then grown epitaxially on the relaxed SiGe layer in order to produce a strained Si-on-SiGe structure.

In this final structure, a layer of relaxed material (in this case, the layer of SiGe) is interposed between the layer of strained material (in this case the Si film) and the oxide. This may substantially reduce the technical performance expected of the Si/SiGe combination, and especially its electrical properties.

Thus, for example, the SiGe layer may have a tendency to increase the circuit capacitances and therefore reduce the switching rates of the electronic components to be produced or produced in the Si/SiGe active part.

The fabrication of electronic components in the active part of such a structure comprising this combination having two layers on insulator also has the risk of being complex to carry out, especially by the creation of lateral insulating regions in the on-insulator combination.

This process furthermore limits the application to the production of an Si/SiGe-on-insulator structure and provides no solution to the production, for example, of a strained Si-on-insulator structure.

Other etch-back techniques and processes have been proposed, for example, in document US 5 013 681, in which an unstrained Si layer is especially transferred.
- the second layer transfer technique reported in the document by Zhi-Yuan Cheng et al. is based on the "Smart-Detachment^{®}" technology of the Applicant, known to those skilled in the art, and descriptions of which may be found in a number of works dealing with wafer reduction techniques: it consists, before bonding, in implanting species into the relaxed SiGe layer so as to create therein an embrittlement zone, at which, after bonding, the donor wafer is detachment.

What is obtained therefore is, on the one hand, a donor wafer, stripped of part of the relaxed SiGe layer, and, on the other hand, a structure comprising, bonded together, a removed thin layer of relaxed SiGe and the receiving substrate.

The Smart-Detachment^{®} technique is advantageous in that it affords the possibility of recycling the donor wafer instead of sacrificing it, unlike the etch-back technique.

Other processes have been proposed, using the two techniques simultaneously.

Documents US 5 882 987 and US 6 323 108 thus disclose an overall process for producing SeOl structures from a donor wafer comprising in succession a single-crystal Si base support substrate, an SiGe layer and an epitaxially grown Si film bonded to an oxidized support substrate.

The Smart-Cut^{®} technique is employed, creating, before bonding, an embrittlement zone in the Si support substrate and, after bonding, causing detachment in the donor wafer in this region.

A structure consisting in succession of part of the Si support substrate, the SiGe layer and the epitaxially grown Si film is thus removed, the whole assembly being bonded to the oxidized receiving substrate.

Two successive selective etching operations are then carried out on the structure in order firstly to remove the remaining part of the Si support substrate with an etching solution such that the SiGe layer forms a stop layer and then in order to remove the SiGe layer with an etching solution such that the Si film forms a stop layer.

The structure obtained at the end is an SeOl structure with a surface Si layer.

The main objective of this process is to produce an SeOl structure with a silicon layer which is both very thin and very uniform through the thickness, using a process which can avoid a finishing step which would otherwise be prejudicial to the quality of the silicon layer.

The main objective of this process is not, however, to produce an SeOl structure with a strained silicon layer.

The SiGe layer used to produce the SeOl structure during implementation of this process has, moreover, a typical thickness of between 0.01 and 0.2 microns, a thickness insufficient, as seen above, to claim to fulfil the role of a buffer layer between the Si support substrate and a potential relaxed SiGe layer.

The silicon of the film grown epitaxially on the SiGe layer and constituting the Si layer of the final SeOl structure therefore seems to be little strained or unstrained, and therefore does not meet the main objective of the invention which is subject of the present document, explained above, which relates to the production of a structure comprising a strained Si layer so as to benefit from its useful electrical properties, especially in SeOl structures.

This type of process therefore seems to be unsuitable for producing a structure comprising a strained Si layer.

The IBM document by L.J. Huang et al. ("SiGe-On-Insulator prepared by wafer bonding and layer transfer for high-performance field-effect transistors", Applied Physics Letters, 26102/2001, Vol. 78, No. 9) discloses for example a process of producing an Si/SGOI structure with strained silicon, starting from a donor wafer comprising in succession a single-crystal Si support substrate, an SiGe buffer layer and a relaxed SiGe layer.

The process employed consists in using the Smart-Cut^{®} technique in the relaxed SiGe layer, thus making it possible, after bonding to an oxidized receiving substrate and after detachment in the embrittlement zone created beforehand, to produce an SGOI structure with relaxed SiGe.

Finally, a film of strained Si is then epitaxially grown on the relaxed SiGe layer in order to produce an Si/SGOI structure.

In this final structure, a layer of relaxed material (i.e. the SiGe layer) is subjacent to the layer of strained material (i.e. the Si film). This may be prejudicial to the performance, especially the electronic performance, expected in this case of the layer of strained material, as already mentioned above.

This process furthermore limits the application to the production of such an Si/SiGe-on-insulator structure and does not provide a solution to the production, for example, of a strained Si-on-insulator structure.

As regards document WO 01/99169, this proposes processes of producing, from a wafer consisting in succession of an Si substrate, an SiGe buffer layer, a relaxed SiGe layer and, optionally, a layer of strained Si or SiGe, a final structure with the relaxed SiGe layer on the optional other strained Si or SiGe layer.

The technique employed to produce such a structure involves, after bonding the wafer to a receiving substrate, removal of material from the wafer that it is not desired to retain, by selectively etching the Si substrate and the SiGe buffer layer.

It transpires that this technique does make it possible to achieve layer thicknesses that are particularly thin and homogeneous through the thickness, but it does entail, however, the destruction of the Si substrate and of the SiGe buffer layer by chemical etching.

These processes do not therefore afford the possibility of reusing part of the wafer, and especially at least part of the buffer layer, for a new layer transfer.

WO 02/15244 document describes a source wafer, provided before transfer, comprising relaxed SiGe layer/strained Si/SiGe layer/buffer SiGe layer/Si subtract structure.

Then, the transfer consists of doing a Smart-Cut® process at the strained Si layer level.

In these conditions, this strained Si layer is a sacrificial layer, and can not become a useful layer in the formed final structure.

WO 02/15244 document describes as well a production of a strained Si/SGOI structure after having transferred a SiGe layer (from a source wafer comprising in succession a relaxed SiGe layer/SiGe buffer layer/Si substrate structure) and after having grown a Si layer on the transferred SiGe.

These processes do not provide a solution to the production of a simple strained silicon-on-insulator structure.

To avoid these drawbacks and the other disadvantages mentioned above, as well as others, the present invention proposes, according to a first aspect, a method of producing a structure comprising a thin layer of strained semiconductor material obtained from a donor wafer, the donor wafer comprising a lattice parameter matching layer comprising an upper layer of a material chosen from semiconductor materials having a first lattice parameter, according to claim 1.

Other preferred aspects of the process according to the invention are the following:
- a process for correcting the surface roughness is carried out after step (d), on the surface of the unremoved part of the matching layer;.
- the removal of the part of the matching layer which remains, comprises at least one operation of selective etching of the matching layer which remains with respect to the material constituting the film;
- after step (a), a step of growing at least one growth layer on the film is additionally carried out, so that the film stays substantially elastically strained;
- the growth layer has a nominal lattice parameter substantially identical to the first lattice parameter;
- between step (a) and step (c), steps of growing, on the film, of layers which are not substantially decreasing the strained state of the film are additional carried out, these growth layers forming a multilayer structure having a respective alternation of layer having the first lattice parameter and of layer strained to have the first lattice parameter, the growth layer directly made on film being a layer having the first lattice parameter;
- between step (a) and step (c), a step of forming at least one bonding layer between the receiving substrate and the donor wafer is additionally carried out, the bonding layer being formed on the receiving substrate and/or on the bonding face of the donor wafer;
- the bonding layer is made of silica;
- step (c) of the bonding is carried out by molecular adhesion (wafer bonding).
- the bonding is accompanied by a thermal treatment in order to strengthen the bonds;
- the embrittlement zone is formed in step (b) by implantation of atomic species into the matching layer, at a depth substantially equal to the implant depth;
- before step (a), the embrittlement zone is formed in step (b) by porosification of a layer beneath the film;
- the film of strained material is made of silicon and the matching layer is made of silicon-germanium, the matching layer comprising a buffer layer with a germanium concentration that increases through the thickness and the upper layer which is relaxed beneath the strained film;
- that part of the matching layer not removed after the supply of energy during step (d), is at least part of the upper relaxed silicon-germanium layer of the matching layer;
- the growth layer is made of relaxed silicon-germanium, with a germanium concentration substantially equal to the germanium concentration of the relaxed upper layer of the matching layer;
- the receiving substrate is made of silicon;
- the wafer comprises at least one layer furthermore containing carbon, with a carbon concentration in the layer substantially less than or equal to 50%; and
- the wafer comprises at least one layer furthermore containing carbon, with a carbon concentration in the layer substantially less than or equal to 5%.

Further aspects, objects and advantages of the present invention will be more clearly apparent on reading the following detailed description of the implementation of preferred processes thereof, these being given by way of non-limiting example and with reference to the appended drawings, in which:
- Figure 1 shows the various steps of a first process for producing an electronic structure comprising a thin layer of strained silicon;
- Figure 2 shows the various steps of a second process for producing an electronic structure comprising a thin layer of strained silicon;
- Figure 3 shows the various steps of a third process for producing an electronic structure comprising a thin layer made of strained silicon; and
- Figure 4 shows the various steps of a fourth process for producing an electronic structure comprising a thin layer of strained silicon.

It is a main objective of the present invention to provide a reliable process for transferring a film of strained material from a donor wafer to a receiving substrate, the assembly then forming the desired electronic structure, without relaxing the strain within the film during transfer.

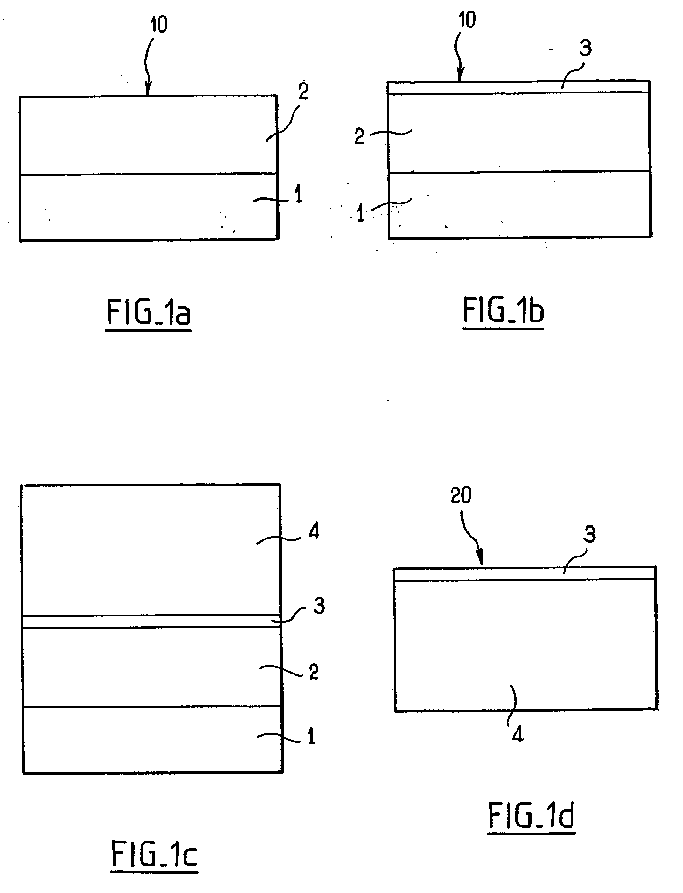

An example of a process will now be described below, which starts, with reference to Figures 1a, 2a, 3a and 4a, from a donor wafer 10 consisting firstly of a single-crystal silicon support substrate 1 and an SiGe lattice parameter matching layer 2.

The expression "lattice parameter matching layer" denotes any structure behaving as a buffer layer and having, on the surface, a layer of substantially relaxed material without an appreciable number of structural defects, such as dislocations.

Thus, in our example, it will be advantageous to choose an SiGe matching layer 2 consisting in succession of an SiGe buffer layer and a relaxed SiGe layer on the surface.

The buffer layer preferably has a germanium concentration which grows uniformly from the interface with the support substrate 1, for reasons which were explained above. Its thickness is typically between 1 and 3 micrometres in order to obtain good structural relaxation on the surface.

The relaxed SiGe layer has advantageously been formed by epitaxy on the surface of the buffer layer and its thickness may vary widely depending on the case, with a typical thickness of between 0.5 and 1 micron.

The germanium concentration in the silicon within the relaxed SiGe layer is typically between 15% and 30% in order to obtain, during the next step (shown by Figures 1b , 2b, 3b or 4b), an epitaxially grown Si film 3 sufficiently strained in order to have appreciable electrical properties and not too strained so as to prevent internal structural defects from appearing.

This 30% limitation represents a typical limitation in the current techniques, but this may be caused to change in the coming years.

With reference to Figures 1b, 2b, 3b and 4b, an Si film 3 is grown on the SiGe matching layer 2.

The Si film 3 is advantageously formed by epitaxy using known techniques such as CVD (chemical vapour deposition) and MBE (molecular beam epitaxy) techniques.

The silicon of the film 3 is then obliged by the matching layer 2 to increase its nominal lattice parameter in order to make it substantially identical to that of its growth substrate and thus introduce internal tensile strains.

These modifications of its internal crystallographic structure will increase the mobility of the charge carriers (such as holes and electrons) by modifying the energy band structure of the silicon crystal.

The electrical properties desired in this invention are thus obtained.

However, it is necessary to form quite a thin Si film 3: too great a film thickness would in fact cause at least relative relaxation of the strain in the thickness of the film towards the nominal lattice parameter of the silicon.

The thickness of the film 3 is thus typically less than 20 nanometers, preferably between 10 and 20 nanometers; above 20 nanometers there is a risk of substantial relaxation of the strain that is desired in the present invention, and below 10 nanometers there is a risk of the thickness of the film causing problems in the fabrication of certain electronic components.

Once this donor wafer 10 containing a strained Si film 3 has been produced, one difficulty resides in implementing a reliable process for transferring the strained film 3 from the donor wafer 10 onto a receiving substrate 4, the whole assembly then forming the desired electronic structure 20 without any relaxation of the strain within the film 3 during transfer.

To solve this particular difficulty, several methods of implementation may be suggested:

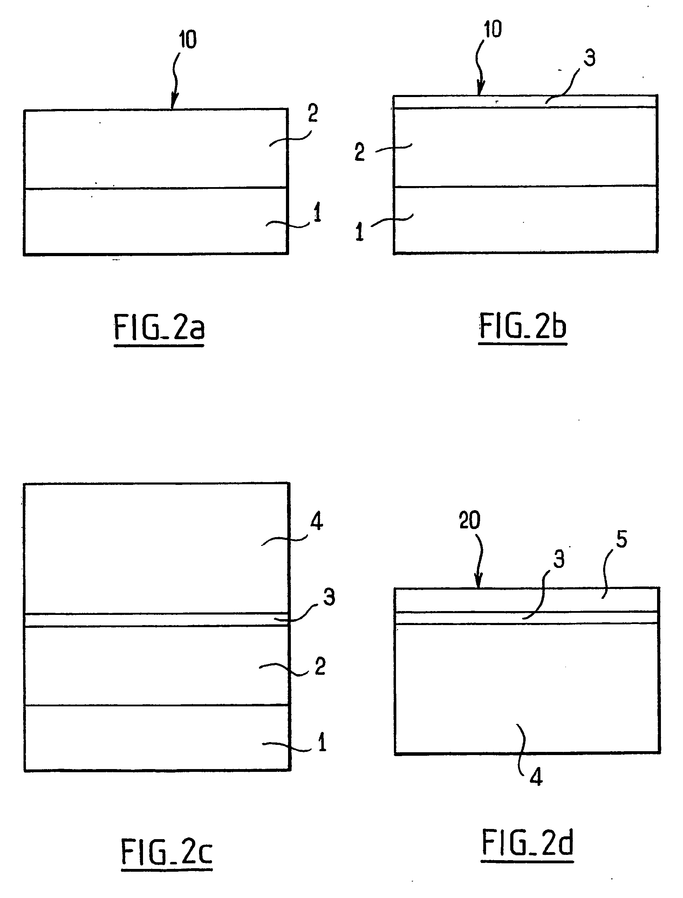

According to a first method of implementing the process, with reference to Figures 1c and 2c, a receiving substrate 4 is attached to the surface of the strained film 3.

This receiving substrate 4 may, for example, be made of silicon or may consist of other types of material.

The receiving substrate 4 is attached by bringing it into intimate contact with the strained Si film 3 and carrying out bonding, in which molecular adhesion between the substrate 4 and the film 3 is advantageously effected.

This bonding technique, as well as variants, is especially described in the document entitled "Semiconductor Wafer Bonding" (Science and Technology, Interscience Technology) by Q.Y. Tong, U. Gösele and Wiley.

If necessary, bonding is accompanied by an appropriate prior treatment of the respective surfaces to be bonded and/or by supplying thermal energy and/or supplying an additional bonding layer.

Thus, for example, a thermal treatment carried out during bonding allows the bonds to be strengthened.

Bonding may also be reinforced by a bonding layer inserted between the film 3 and the receiving substrate 4, which makes it possible to produce molecular bonds both with the film 3 and with the material constituting the bonding face of the receiving substrate 4 which are stronger than those existing between the film 3 and the receiving substrate 4.

Thus, silicon oxide (also called silica or SiO₂) is a material that may be chosen for producing such a bonding layer, since it exhibits good adhesion with the silicon of the film 3. The silica may be formed on the film 3 and/or on the receiving substrate 4 by SiO₂ deposition or by thermal oxidation on the respective bonding surfaces.

Advantageously, the material constituting the bonding face of the receiving substrate 4 and/or the material of the bonding layer optionally formed is electrically insulating, so that there exists an insulating layer directly adjacent to the strained Si film 3: a conducting or semiconducting material directly adjacent to the film 3 could in fact impair the electrical effects desired here in a structure consisting of the combination of the two materials.

This advantageous choice of insulating material adjacent to the film 3 becomes particularly necessary when the structure 20 that it is desired to produce in the end is an SeOl structure, the semiconductor layer of the SeOl structure then being the transferred film 3 of strained Si.

Moreover, the receiving substrate 4 bonded to the strained Si film 3 makes it possible to retain substantially the strained structural state of the strained Si of the film 3, this being so even if the donor wafer 10 on which the strained Si film 3 has been grown epitaxially is removed, the strain within the film 3 being mainly ensured after transfer by the bonding forces existing between the film 3 and the receiving substrate 4.

Transfer of the strained film 3 from the donor wafer 10 to the receiving substrate 4 without relaxing the strain within the film 3 is thus made possible, thereby solving the abovementioned difficulty.

The receiving substrate 4 furthermore constitutes a mechanical support sufficiently rigid to sustain the strained Si film 3 and protect it from any mechanical stresses coming from the outside.

Once the receiving substrate 4 has been bonded, part of the donor wafer 10 is removed using one or more of the preferred techniques that will be explained later, in order to transfer the strained Si film 3 to the receiving substrate and to produce the desired structure 20.

In a first case, with reference to Figure 1d, substantially all that part of the donor wafer 10 on the matching layer 2 side in relation to the strained film 3 is removed.

Thus, a final strained Si-on-substrate structure, and in particular a strained Si-on-insulator structure (also called here an SOI structure), is obtained if the material subjacent to the strained Si film 3 is an electrical insulator.

In a second case which is not part of the invention, with reference to Figure 2d, the support substrate 1 and part of the matching layer 2 are removed.

Thus, a final SiGe-on-strained Si-on-substrate structure, and in particular an SiGe-on-strained Si-on-insulator structure (also called SiGe/SOI structure), is obtained if the material underlying the strained Si film 3 is an electrical insulator.

The removal of part of the matching layer 2 is advantageously carried out so as to preserve of the matching layer 2 on the structure 20, only at least part of the relaxed SiGe layer included in the matching layer 2 (and which had been epitaxially grown according to one particular method of producing the matching layer 2 explained above, on a buffer layer).

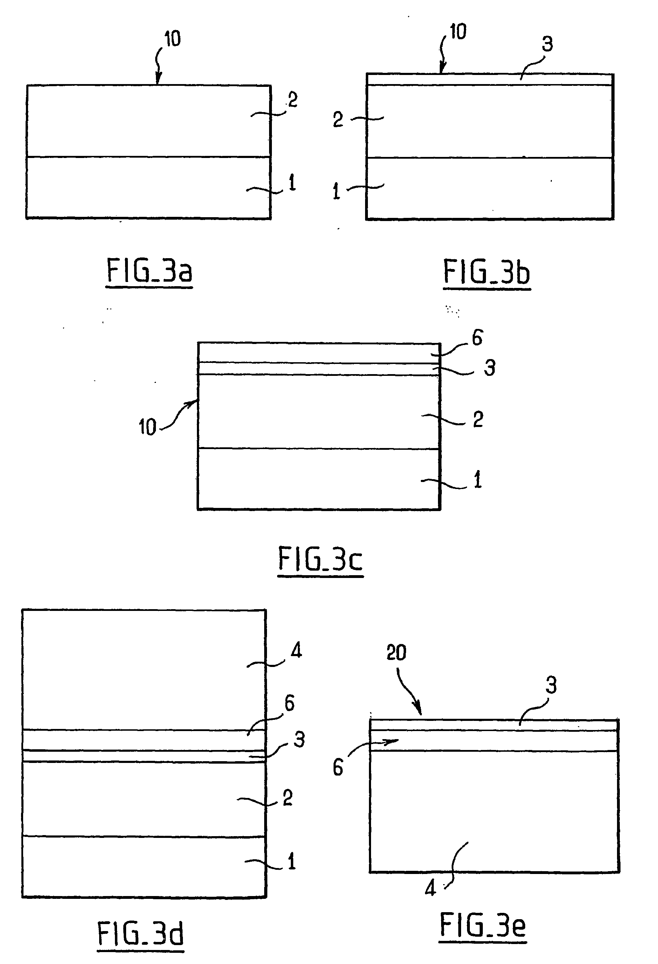

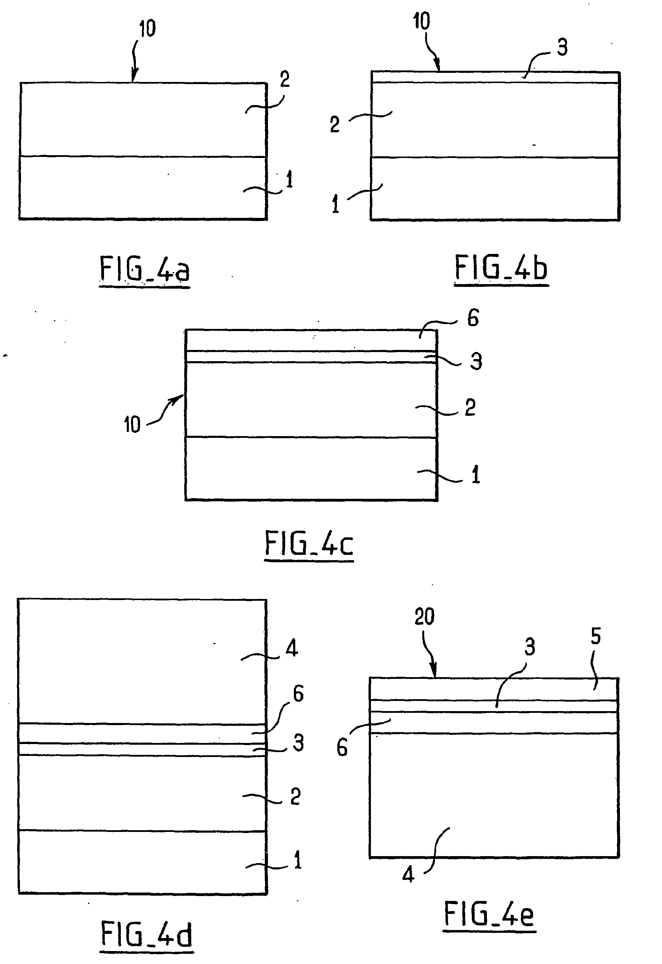

According to a second method of implementing the process, with reference to Figures 3c and 4c, a relaxed SiGe layer 6 is grown on the strained Si film 3, by epitaxy (for example by CVD or MBE) advantageously before any bonding operation.

The Ge concentration in this layer 6 is advantageously and substantially the same as that of the SiGe present near the bonding face of the matching layer 2 so as to prevent this layer having an additional influence on the strain in the film 3.

In one particular method of implementation, further layers may be grown epitaxially on the SiGe layer, such as strained Si or SiC layers and SiGe or SiGeC layers respectively alternating in order to form a multilayer structure.

Referring to Figures 3d and 4d, a receiving substrate 4 is bonded to the relaxed SiGe layer 6 in a manner substantially identical to that explained above in the first method of implementation and relating to a receiving substrate 4 bonded to the strained film 3.

The bonding face of the donor wafer 10 is then the free face of the relaxed SiGe layer 6.

It should be pointed out that, unlike the first method of implementation, the bonds do not necessarily constitute the only means of preserving the strain in the film 3: this is because, if the relaxed SiGe layer 6 is thick enough, it may participate in, or even guarantee, the preservation of the strain in the film 3 after these two layers have been transferred.

The thickness of the SiGe epilayer 6 may thus be judiciously chosen in this regard so as to preserve greater or lesser amounts of the strain in the Si layer.

As in the first method of implementation, once the receiving substrate 4 has been bonded, part of the donor wafer 10 is removed using one or more of the preferred techniques that will be explained below, in order to transfer the strained Si film 3 to the receiving substrate 4 and to produce the desired structure 20.

In a first case, with reference to Figure 3e, all that part of the donor wafer 10 on the matching layer 2 side in relation to the layer 6 is removed.

Thus, a final strained Si-on-relaxed SiGe-on-substrate structure, and in particular a strained Si-on-relaxed SiGe-on-insulator structure (also called an Si/SGOI structure), is obtained if the material underlying the relaxed SiGe layer 6 is an electrical insulator.

In a second case which is not part of the invention, with reference to Figure 4e, the Si support substrate 1 and part of the matching layer 2 are removed.

Thus, a final SiGe-on-strained Si-on-relaxed SiGe-on-substrate structure, and in particular an SiGe-on-strained Si-on-relaxed SiGe-on-insulator structure (also called an SiGe/Si/SGOI structure), is obtained if the material subjacent to the relaxed SiGe layer 6 is an electrical insulator.

Part of the matching layer 2 is advantageously removed so as to preserve of the matching layer 2 on the structure 20 only at least part of the relaxed SiGe layer present in the matching layer 2 (and which had been epitaxially grown, using one particular method of producing the matching layer 2 explained above, on a buffer layer).

Thus, by means of these processes several structures (shown for example in Figures 1d, 2d, 3e and 4e) comprising a layer of strained material can be produced, each having very specific electrical properties.

With reference to Figures 1d, 2d, 3e and 4e, removal of material constitutes the final step of producing such structures.

A first material removal operation consists in detachment the donor wafer in a region of the matching layer 2 that has previously been weakened therein.

Two known non-limiting techniques may thus perform such an operation.

A first technique, called the Smart-Detachment® technique, known to those skilled in the art (and descriptions of which may be found in a number of works dealing with wafer reduction techniques), consists in implanting atom species (such as hydrogen ions) and then in subjecting the implanted region, which then forms an embrittlement zone, to a heat treatment and/or mechanical treatment, or another supply of energy, in order to make the detachment in the embrittlement zone.

Detachment from an embrittlement zone thus formed in the matching layer 2 makes it possible to remove most of the wafer 10, in order to obtain a structure comprising the remainder of the matching layer 2, the strained Si film 3, optionally epitaxially grown overlayers such as the layer 6, the optional bonding layer and the receiving substrate 4.

A second technique consists in obtaining a weak interface by creating at least one porous layer, as described for example in document EP-A-0 849 788, and then in subjecting the weak layer to a mechanical treatment, or another supply of energy, in order to make the detachment in the weakened layer.

The weakened layer made of porous silicon is formed between the support substrate 1 and the matching layer 2, in the matching layer 2 (for example between a buffer layer and a relaxed layer) or on the matching layer 2 (that is to say between the matching layer 2 and the strained Si film 3 or the optional relaxed SiGe layer 6).

Detachment a weakened layer makes it possible to remove at least some of the wafer 10, in order to obtain a structure comprising the optional remainder of the wafer 10, the strained Si film 3, optionally epitaxially grown overlayers such as the layer 6, optionally the inserted bonding layer and the receiving substrate 4.

A treatment of the wafer 10, in order to remove the porous silicon which remains after the detachment, is advantageously carried out, such as an etching operation or a thermal treatment.

If the porous layer lies within the support substrate 1, a lapping, chemical-mechanical polishing and/or selective chemical etching operations are then advantageously carried out in order to remove the remaining part of the support substrate 1.

These two non-limiting techniques make it possible to rapidly remove, en bloc, a substantial part of the wafer 10.

They also allow the possibility of reusing the removed part of the wafer 10 in another process, such as for example a process according to the invention.

Thus, if the part removed is the support substrate 1, an operation to reform a matching layer 2, a film 3 and an optional SiGe layer 6 and/or other layers may be carried out as described above, after the surface of the support substrate 1 has been polished.

If the removed part is the support substrate 1 and at least part of the matching layer 2, a possible reformation of another part of the matching layer 2, of a film 3 and of an SiGe layer 6 and/or other layers may be carried out as described above, after the surface of the remaining part of the matching layer 2 has been polished.

A second material removal operation after detachment the wafer 10 according, for example, to one of the above two techniques consists in correcting surface defects or in removing, if necessary, the remaining part of the matching layer 2.

According to the invention it is essential to remove all of the remaining part of the matching layer 2 (referring to Figures 1d and 3e); this operation may be carried out by selective chemical etching so that the strained Si film 3 undergoes little or no etching, thus forming an etching stop layer.

The remaining part of the matching layer 2 is in this case etched by wet etching using etching solutions having substantial selectivities with respect to the strained Si film 3, such as a solution comprising HF/H₂O₂/CH₃COOH (approximately 1/1000 selectivity) or HNA (hydrofluoric-nitric-acetic solution).

Dry etching operations may also be carried out in order to remove material, such as plasma etching, or by sputtering.

This chemical method has the main advantage of being quite rapid for thin layers to be removed and of avoiding the use of chemical-mechanical polishing finishing operations usually employed after detachment the wafer.

It thus makes it possible to maintain good surface quality and good thickness homogeneity of the strained Si film 3 obtained during its epitaxy, it having been unnecessary to carry out a mechanical finishing step in the case in which the material removal is completed by a single chemical operation, thus preventing defects from appearing, such as strain-hardened regions, that such a mechanical finishing step is likely to cause.

In certain particular cases, soft polishing is, however, used in order to compensate for any small surface roughnesses.

However, the chemical etching operation may advantageously be preceded, especially in the case of a thicker layer to be removed, by mechanical or chemical-mechanical abrasion by lapping and/or chemical-mechanical polishing CMP of the remaining part of the matching layer 2.

If it is desired to maintain part of the matching layer 5 (referring to Figures 2d and 4e), it will be advantageous to choose a thermal treatment or a polishing, preferably chemical-mechanical polishing CMP, in order to remove any roughnesses and thickness homogeneities that might have appeared during detachment of the wafer 10.

However, etching selectivity with respect to the Ge concentration present in the matching layer 2 (and which increases with the thickness of the matching layer 2) may also be employed, the etching slowing down or stopping on the relaxed layer lying within the matching layer 2.

Wet etching with a solution comprising TMAH may, for example, be very suitable for carrying out such selective etching, the relaxed layer of the matching layer 2 having in this case a germanium concentration of between 20% and 30%.

These techniques are proposed by way of an example in the present document, but they do not in any way constitute a limitation, the invention covering all types of techniques suitable for removing material from a donor wafer 10 in accordance with the process according to the invention.

In one particular embodiment of the structure 20, one or more epitaxial depositions may be carried out on the donor wafer 10, such as epitaxial deposition of an SiGe or SiGeC layer, or epitaxial deposition of a strained Si or SiC layer, or successive epitaxial depositions of SiGe or SiGeC layers and strained Si or SiC layers in alternation, in order to form a multilayer structure.

According to the invention, a growth of Si is operating on the film 3 to thicken it.

A first interest of doing a such growth of Si of re-finding the initial thickened of the film 3, which may nevertheless be thinned by soft polishing etching or event cleaning operation.

A second interest concerns the insulating layer underlying the film 3 and being of a viscous material, as for example SiO₂ or Si₃N₄, wherein the film 3 can be thickened so that its thickness becomes more important than the "standard Si critical thickness", without losing its elastic stress.

The "standard Si critical thickness" can be found from the stress ratio value of the film 3 and from the fact that this stress ratio can be directly associated with the Ge concentration of a Si₁₋ₓGeₓ substrate (i.e. the x value) on which the film 3 had been or would have been grown ; if the stress ratio of the film 3 has not changed since the growth of the film 3, the associated Ge concentration is those of the Si₁₋ₓGeₓ substrate on which the film 3 has been grown before transfer.

The "standard critical thickness" value of the film 3 can thus be directly associated with a Ge concentration of a Si₁₋ₓGeₓ substrate on which the film 3 had been or would have been grown. Some examples of "standard critical thickness" can then be found in "High-Mobility Si and Ge structures" of Friedrich Schaffler ("Semiconductor Science Technology" 12 (1997) 1515-1549).

Thus, the applicant notices that, in a structure including a viscous material layer and a strained Si film 3 on the viscous material layer, the critical thickness of the film 3 (beyond which the film 3 is not mainly elastically strained) is typically more important than its standard critical thickness.

This property may result from the viscosity of the insulator layer which should accommodate with the Si internal stress.

Thus, experience shows that it is possible to increase the thickness of the film 3 about 60 nanometers, without substantial loss of stress.

The thick strained Si layer can then be used as an active layer (taking thus advantage of electrons high mobility that a such material exhibits).

Having completed the final structure, a finishing step may optionally be carried out, such as finishing treatments, for example like an annealing operation in order to further strengthen the bonding interface between the donor wafer 10 and the receiving substrate 4.

The present invention is not limited to a SiGe lattice parameter matching layer 2, but also extends to a constitution of the matching layer 2 from other types of type III-V materials or other materials capable of straining the material of the epitaxially overgrown film 3 or another semiconductor material.

Finally, the present invention does not relate only to transferring a strained silicon film 3, but in general relates to transferring a film of any type of semiconductor able to be strained and transferred according to a process of the invention.

In the semiconductor layers, other constituents may be added thereto, such as carbon with a carbon concentration in the layer in question substantially of less than or equal to 50% or more particularly with a concentration of less than or equal to 5%.

## Claims

1. Method of producing a structure comprising a thin layer of strained semiconductor material obtained from a donor wafer (10), the donor wafer (10) comprising a lattice parameter matching layer (2) comprising an upper layer of a material chosen from semiconductor materials having a first lattice parameter, wherein the method comprises the following steps:
(a) growth of a film (3) of a material chosen from semiconductor materials on the upper layer of the matching layer (2), which film (3) being of material having a nominal lattice parameter substantially different from the first lattice parameter, wherein the grown film has a thickness small enough to keep the first lattice parameter of the upper layer of the underlyed matching layer and thus to be strained;
(b) weakening a region of the matching layer (2);
(c) bonding of a receiving substrate (4) with the donor wafer (10) on the film (3) side; and
(d) removal of a part of the donor wafer (10), comprising supply of energy in order to detach at the weakened region level, the part of the donor wafer (10) comprising the film (3);
and in that it further comprises :
• a formation of a layer made of a viscous material, said material becoming viscous from a predetermined temperature, on the surface of the receiving substrate (4), before step (c) ;
• a growth of a material being substantially the same as the one of the film (3), on the film (3), after having removed the remaining matching layer (2) in step (d),
wherein the film (3) thickened by said growth of material remains substantially elastically strained.

2. Method of producing a structure according to the preceding claim, **characterized in that** a process for correcting the surface roughness is carried out after step (d), on the surface of the unremoved part of the matching layer (5).

3. Method of producing a structure according to the preceding claim, **characterized in that** the removal of the part of the matching layer which remains, comprises at least one operation of selective etching of the matching layer (2) which remains with respect to the material constituting the film (3).

4. Method of producing a structure according to one of the preceding claims, **characterized in that**, after step (a), a step of growing at least one growth layer (6) on the film (3) is additionally carried out, so that the film (3) stays substantially elastically strained.

5. Method of producing a structure according to the preceding claim, **characterized in that** the growth layer (6) has a nominal lattice parameter substantially identical to the first lattice parameter.

6. Method of producing a structure according to one of Claims 1 to 5, **characterized in that**, between step (a) and step (c), steps of growing, on the film (3), of layers which are not substantially decreasing the strained state of the film (3) are additionally carried out, these growth layers forming a multilayer structure having a respective alternation of layer having the first lattice parameter and of layer strained to have the first lattice parameter, the growth layer (6) directly made on film (3) being a layer having the first lattice parameter.

7. Method of producing a structure according to one of the preceding claims, **characterized in that**, between step (a) and step (c), a step of forming at least one bonding layer between the receiving substrate (4) and the donor wafer (10) is additionally carried out, the bonding layer being formed on the receiving substrate (4) and/or on the bonding face of the donor wafer (10).

8. Method of producing a structure according to the preceding claim, **characterized in that** the bonding layer is made of silica.

9. Method of producing a structure according to one of the preceding claims, **characterized in that** step (c) of the bonding is carried out by molecular adhesion (wafer bonding).

10. Method of producing a structure according to one of the preceding claims, **characterized in that** the bonding is accompanied by a thermal treatment in order to strengthen the bonds.

11. Method of producing a structure according to one of the preceding claims, **characterized in that** the weakened region is an embrittlement zone is formed in step (b) by implantation of atomic species into the matching layer (2), at a depth substantially equal to the implant depth.

12. Method of producing a structure according to one of Claims 1 to 10, **characterized in that**, before step (a), the weakened region is formed in step (b) by porosification of a layer beneath the film (3).

13. Method of producing a structure according to one of the preceding claims, **characterized in that** the film (3) of strained material is made of silicon and the matching layer (2) is made of silicon-germanium, the matching layer (2) comprising a buffer layer with a germanium concentration that increases through the thickness and the upper layer which is relaxed beneath the strained film (3).

14. Method of producing a structure according to the preceding claim, **characterized in that that** part of the matching layer (5) not removed after the supply of energy during step (d), is at least part of the upper relaxed silicon-germanium layer of the matching layer (2).

15. Method of producing a structure according to either of the two preceding claims, combined with one of the Claims 4 to 6, **characterized in that** the growth layer (6) is made of relaxed silicon-germanium, with a germanium concentration substantially equal to the germanium concentration of the relaxed upper layer of the matching layer (2).

16. Method of producing a structure according to one of the preceding claims, **characterized in that** the receiving substrate (4) is made of silicon.

17. Method of producing a structure according to one of the preceding claims, **characterized in that** the wafer (10) comprises at least one layer furthermore containing carbon, with a carbon concentration in the layer substantially less than or equal to 50%.

18. Method of producing a structure according to one of the preceding claims, **characterized in that** the wafer (10) comprises at least one layer furthermore containing carbon, with a carbon concentration in the layer substantially less than or equal to 5%.

## Patentansprüche

1. Verfahren zur Herstellung einer Struktur, die eine dünne Schicht eines von einem Spenderwafer (10) erhaltenen verspannten Halbleitermaterials umfasst, wobei der Spenderwafer (10) eine Gitterparameteranpassungsschicht (2) umfasst, die eine obere Schicht aus einem Material umfasst, das aus Halbleitermaterialien mit einem ersten Gitterparameter ausgewählt ist, wobei das Verfahren die folgenden Schritte umfasst:
(a) Aufwachsen eines Films (3) aus einem Material, das aus Halbleitermaterialien ausgewählt ist, auf der oberen Schicht der Anpassungsschicht (2), wobei der Film (3) aus einem Material besteht, das einen Nenn-Gitterparameter aufweist, der sich von dem ersten Gitterparameter wesentlich unterscheidet, wobei der aufgewachsene Film eine Dicke aufweist, die gering genug ist, um den ersten Gitterparameter der oberen Schicht der darunter liegenden Anpassungsschicht beizubehalten, und somit verspannt zu werden;
(b) Schwächen einer Region der Anpassungsschicht (2);
(c) Bonden eines Empfangssubstrats (4) mit dem Spenderwafer (10) auf der Seite des Films (3); und
(d) Entfernen eines Teils des Spenderwafers (10), wobei der Schritt das Zuführen von Energie umfasst, um auf Höhe der geschwächten Region den Teil des Spenderwafers (10), der den Film (3) umfasst, abzutrennen;
und wobei das Verfahren ferner umfasst:
• Ausbilden einer Schicht aus einem viskosen Material, das ab einer vorgegebenen Temperatur viskos ist, auf der Oberfläche des Empfangssubstrats (4), bevor Schritt (c) ausgeführt wird;
• Aufwachsen eines Materials, das im Wesentlichen das gleiche ist wie dasjenige des Films (3), auf dem Film (3), nachdem die verbliebene Anpassungsschicht (2) in Schritt (d) entfernt wurde,
wobei der Film (3), dessen Dicke durch das Aufwachsen von Material vergrößert wird, im Wesentlichen elastisch verspannt bleibt.

2. Verfahren zur Herstellung einer Struktur nach dem vorangegangenen Anspruch, **dadurch gekennzeichnet, dass** nach Schritt (d) ein Prozess zum Korrigieren der Oberflächenrauheit auf der Oberfläche des nicht entfernten Teils der Anpassungsschicht (5) ausgeführt wird.

3. Verfahren zur Herstellung einer Struktur nach dem vorangegangenen Anspruch, **dadurch gekennzeichnet, dass** das Entfernen des verbliebenen Teils der Anpassungsschicht mindestens einen Vorgang des selektiven Ätzens der verbliebenen Anpassungsschicht (2) mit Bezug auf das den Film (3) bildende Material umfasst.

4. Verfahren zur Herstellung einer Struktur nach einem der vorangehenden Ansprüche, **dadurch gekennzeichnet, dass** nach Schritt (a) zusätzlich ein Schritt des Aufwachsens mindestens einer Wachstumsschicht (6) auf dem Film (3) ausgeführt wird, so dass der Film (3) im Wesentlichen elastisch verspannt bleibt.

5. Verfahren zur Herstellung einer Struktur nach dem vorangegangenen Anspruch, **dadurch gekennzeichnet, dass** die Wachstumsschicht (6) einen Nenn-Gitterparameter aufweist, der mit dem ersten Gitterparameter im Wesentlichen identisch ist.

6. Verfahren zur Herstellung einer Struktur nach einem der Ansprüche 1 bis 5, **dadurch gekennzeichnet, dass** zwischen Schritt (a) und Schritt (c) zusätzlich Schritte des Aufwachsens von Schichten, die den Verspannungszustand des Films (3) nicht wesentlich verringern, auf dem Film (3) ausgeführt werden, wobei diese Wachstumsschichten eine mehrschichtige Struktur bilden, in der sich eine Schicht, die den ersten Gitterparameter aufweist, und eine Schicht, die so verspannt ist, dass sie den ersten Gitterparameter aufweist, jeweils abwechseln, wobei die Wachstumsschicht (6), die direkt auf dem Film (3) ausgebildet ist, eine Schicht ist, die den ersten Gitterparameter aufweist.

7. Verfahren zur Herstellung einer Struktur nach einem der vorangehenden Ansprüche, **dadurch gekennzeichnet, dass** zwischen Schritt (a) und Schritt (c) zusätzlich ein Schritt des Ausbildens mindestens einer Bondungsschicht zwischen dem Empfangssubstrat (4) und dem Spenderwafer (10) ausgeführt wird, wobei die Bondungsschicht auf dem Empfangssubstrat (4) und/oder auf der Bondungsfläche des Spenderwafers (10) ausgebildet wird.

8. Verfahren zur Herstellung einer Struktur nach dem vorangegangenen Anspruch, **dadurch gekennzeichnet, dass** die Bondungsschicht aus Siliciumdioxid besteht.

9. Verfahren zur Herstellung einer Struktur nach einem der vorangehenden Ansprüche, **dadurch gekennzeichnet, dass** der Schritt (c) des Bondens durch molekulare Adhäsion (Waferbondung) ausgeführt wird.

10. Verfahren zur Herstellung einer Struktur nach einem der vorangehenden Ansprüche, **dadurch gekennzeichnet, dass** mit dem Bonden eine Wärmebehandlung einhergeht, um die Bindungen zu festigen.

11. Verfahren zur Herstellung einer Struktur nach einem der vorangehenden Ansprüche, **dadurch gekennzeichnet, dass** die geschwächte Region eine Versprödungszone ist, die in Schritt (b) durch Implantieren von atomaren Spezies in die Anpassungsschicht (2) auf eine Tiefe, die im Wesentlichen gleich der Implantattiefe ist, ausgebildet wird.

12. Verfahren zur Herstellung einer Struktur nach einem der Ansprüche 1 bis 10, **dadurch gekennzeichnet, dass** vor dem Schritt (a) die geschwächte Region in Schritt (b) durch Porosifizierung einer Schicht unterhalb des Films (3) ausgebildet wird.

13. Verfahren zur Herstellung einer Struktur nach einem der vorangehenden Ansprüche, **dadurch gekennzeichnet, dass** der Film (3) aus verspanntem Material aus Silizium besteht und die Anpassungsschicht (2) aus Silizium-Germanium besteht, wobei die Anpassungsschicht (2) eine Pufferschicht mit einer Germaniumkonzentration, die durch die Dicke hindurch zunimmt, und die obere Schicht, die unterhalb des verspannten Films (3) entspannt ist, umfasst.

14. Verfahren zur Herstellung einer Struktur nach dem vorangegangenen Anspruch, **dadurch gekennzeichnet, dass** der Teil der Anpassungsschicht (5), der nach der Energiezufuhr während des Schrittes (d) nicht entfernt wurde, mindestens ein Teil der oberen entspannten Silizium-Germanium-Schicht der Anpassungsschicht (2) ist.

15. Verfahren zur Herstellung einer Struktur nach einem der beiden vorangehenden Ansprüche in Kombination mit einem der Ansprüche 4 bis 6, **dadurch gekennzeichnet, dass** die Wachstumsschicht (6) aus entspanntem Silizium-Germanium besteht, mit einer Germaniumkonzentration, die im Wesentlichen gleich der Germaniumkonzentration der entspannten oberen Schicht der Anpassungsschicht (2) ist.

16. Verfahren zur Herstellung einer Struktur nach einem der vorangehenden Ansprüche, **dadurch gekennzeichnet, dass** das Empfangssubstrat (4) aus Silizium besteht.

17. Verfahren zur Herstellung einer Struktur nach einem der vorangehenden Ansprüche, **dadurch gekennzeichnet, dass** der Wafer (10) mindestens eine Schicht umfasst, die des Weiteren Kohlenstoff enthält, mit einer Kohlenstoffkonzentration in der Schicht von im Wesentlichen maximal 50 %.

18. Verfahren zur Herstellung einer Struktur nach einem der vorangehenden Ansprüche, **dadurch gekennzeichnet, dass** der Wafer (10) mindestens eine Schicht umfasst, die des Weiteren Kohlenstoff enthält, mit einer Kohlenstoffkonzentration in der Schicht von im Wesentlichen maximal 5 %.

## Revendications

1. Procédé de production d'une structure comprenant une couche mince de matériau semi-conducteur contraint obtenue à partir d'une plaquette donneuse (10), la plaquette donneuse (10) comprenant une couche d'adaptation de paramètre de maille (2) qui comprend une couche supérieure constituée d'un matériau choisi parmi les matériaux semi-conducteurs et présentant un premier paramètre de maille, dans lequel le procédé comprend les étapes suivantes :
(a) faire croître un film (3) constitué d'un matériau choisi parmi les matériaux semi-conducteurs sur la couche supérieure de la couche d'adaptation (2), ledit film (3) étant constitué d'un matériau dont le paramètre de maille est sensiblement différent du premier paramètre de maille, dans lequel le film en croissance présente une épaisseur suffisamment petite pour conserver le premier paramètre de maille de la couche supérieure de la couche d'adaptation sous-jacente et donc pour être contraint ;
(b) fragiliser une région de la couche d'adaptation (2) ;
(c) coller un substrat récepteur (4) à la plaquette donneuse (10) du côté du film (3) ; et
(d) enlever une partie de la plaquette donneuse (10), comprenant la fourniture d'énergie dans le but de détacher au niveau de la région fragilisée la partie de la plaquette donneuse (10) qui comporte le film (3) ;
et en ce qu'il comprend en outre les étapes suivantes :
• former une couche constituée d'une matière visqueuse, ladite matière devenant visqueuse à partir d'une température prédéterminée, sur la surface du substrat récepteur (4), avant l'étape (c) ;
• faire croître un matériau qui est sensiblement le même que celui du film (3), sur le film (3), après avoir enlevé la couche d'adaptation restante (2) à l'étape (d),
dans lequel le film (3) épaissi par ladite croissance de matériau reste sensiblement élastiquement contraint.

2. Procédé de production d'une structure selon la revendication précédente, **caractérisé en ce qu'**un procédé pour corriger la rugosité de surface est exécuté après l'étape (d), sur la surface de la partie non enlevée de la couche d'adaptation (5).

3. Procédé de production d'une structure selon la revendication précédente, **caractérisé en ce que** l'enlèvement de la partie de la couche d'adaptation qui reste comprend au moins une opération de gravure sélective de la couche d'adaptation (2) qui reste par rapport à la matière qui constitue le film (3).

4. Procédé de production d'une structure selon l'une des revendications précédentes, **caractérisé en ce que**, après l'étape (a), une étape de croissance d'au moins une couche de croissance (6) sur le film (3) est exécutée de façon additionnelle, de telle sorte que le film (3) reste sensiblement élastiquement contraint.

5. Procédé de production d'une structure selon la revendication précédente, **caractérisé en ce que** la couche de croissance (6) présente un paramètre de maille nominal qui est sensiblement identique au premier paramètre de maille.

6. Procédé de production d'une structure selon l'une des revendications 1 à 5, **caractérisé en ce que**, entre l'étape (a) et l'étape (c), des étapes de croissance, sur le film (3), de couches qui ne diminuent pas sensiblement l'état contraint du film (3) sont exécutées de façon additionnelle, ces couches de croissance formant une structure multicouche qui présente une alternance respective d'une couche qui présente le premier paramètre de maille et une couche contrainte de façon à présenter le premier paramètre de maille, la couche de croissance (6) qui est formée directement sur le film (3) étant une couche qui présente le premier paramètre de maille.

7. Procédé de production d'une structure selon l'une des revendications précédentes, **caractérisé en ce que**, entre l'étape (a) et l'étape (c), une étape de formation d'au moins une couche de collage entre le substrat récepteur (4) et la plaquette donneuse (10) est exécutée de façon additionnelle, la couche de collage étant formée sur le substrat récepteur (4) et/ou sur la face de collage de la plaquette donneuse (10).

8. Procédé de production d'une structure selon la revendication précédente, **caractérisé en ce que** la couche de collage est constituée de silice.

9. Procédé de production d'une structure selon l'une des revendications précédentes, **caractérisé en ce que** l'étape de collage (c) est exécutée par adhésion moléculaire (collage de plaquette).

10. Procédé de production d'une structure selon l'une des revendications précédentes, **caractérisé en ce que** le collage est accompagné d'un traitement thermique qui a pour but de renforcer les liaisons.

11. Procédé de production d'une structure selon l'une des revendications précédentes, **caractérisé en ce que** la région fragilisée est une zone de fragilisation qui est formée à l'étape (b) en implantant des espèces atomiques dans la couche d'adaptation (2) à une profondeur qui est sensiblement égale à la profondeur d'implant.

12. Procédé de production d'une structure selon l'une des revendications 1 à 10, **caractérisé en ce que**, avant l'étape (a), la région fragilisée est formée à l'étape (b) en rendant poreuse une couche en dessous du film (3).

13. Procédé de production d'une structure selon l'une des revendications précédentes, **caractérisé en ce que** le film (3) de matériau contraint est constitué de silicium, et la couche d'adaptation (2) est constituée de silicium - germanium, la couche d'adaptation (2) comprenant une couche tampon dont la concentration en germanium augmente à travers l'épaisseur et la couche supérieure qui est relaxée en dessous du film contraint (3).

14. Procédé de production d'une structure selon l'une des revendications précédentes, **caractérisé en ce que** la partie de la couche d'adaptation (5) qui n'est pas enlevée après la fourniture d'énergie à l'étape (d), est au moins une partie de la couche supérieure de silicium - germanium relaxée de la couche d'adaptation (2).

15. Procédé de production d'une structure selon l'une des deux revendications précédentes, combinée avec l'une des revendications 4 à 6, **caractérisé en ce que** la couche de croissance (6) est constituée de silicium - germanium relaxé, avec une concentration en germanium qui est sensiblement égale à la concentration en germanium de la couche supérieure relaxée de la couche d'adaptation (2).

16. Procédé de production d'une structure selon l'une des revendications précédentes, **caractérisé en ce que** le substrat récepteur (4) est constitué de silicium.

17. Procédé de production d'une structure selon l'une des revendications précédentes, **caractérisé en ce que** la plaquette (10) comprend au moins une couche qui contient en outre du carbone, avec une concentration en carbone dans la couche qui est sensiblement inférieure ou égale à 50 %.

18. Procédé de production d'une structure selon l'une des revendications précédentes, **caractérisé en ce que** la plaquette (10) comprend au moins une couche qui contient en outre du carbone, avec une concentration en carbone dans la couche qui est sensiblement inférieure ou égale à 5 %.
